# DEMANDE DE BREVET EUROPEEN

(11) **EP 1 011 142 A1**
(43) Date de publication de la demande: **21.06.2000**
(21) Numéro de dépôt: 99403172.2
(22) Date de dépôt: 16.12.1999
(51) Int. Cl.: H01L 23/66, H01L 23/64

(54) **Dispositif semi-conducteur avec substrat sur isolant à découplage de bruit**

(30) Priorité: 17.12.1998 FR 9815940
(71) Demandeur: STMicroelectronics SA, 94250 Gentilly Cedex (FR)
(72) Inventeur: Belot, Didier, 38140 Rives (FR)
(74) Mandataire: Casalonga, Axel

(57) **Abrégé**

Le circuit intégré (CI) est réalisé sur un substrat sur isolant. Le découplage substrat est réalisé par un caisson de découplage (BC2) disposé entre un émetteur de bruit (BC3) et un récepteur de bruit (BC1). La capacité caisson-substrat (C2) du caisson et de couplage est supérieure aux capacités caisson-substrat (C3, C1) de l'émetteur et du récepteur.

## Description

L'invention concerne les dispositifs semi-conducteurs, et plus particulièrement le découplage entre un émetteur de bruit et un récepteur sensible au bruit réalisés à l'intérieur d'un circuit intégré sur un substrat du type substrat sur isolant (substrat SOI : "Substrat On Insulator" en langue anglaise).

Le bruit de couplage de l'intérieur d'un circuit intégré provient essentiellement de deux sources, à savoir le couplage électromagnétique dû au boîtier et aux lignes métalliques du circuit, et le couplage électrique dû au substrat.

La présente invention vise plus particulièrement à résoudre le problème du bruit de couplage électrique dû au substrat.

Plus précisément, lorsqu'un émetteur de bruit injecte des charges dans le substrat, celles-ci se répartissent de façon uniforme et peuvent alors être captées par un récepteur dont le fonctionnement peut être perturbé si celui-ci est sensible à ce bruit électrique.

A titre indicatif, un émetteur de bruit au sens de la présente invention peut être par exemple un transistor fort signal injectant des charges dans le substrat, charges captées par un transistor faible signal qui se comporte alors comme un récepteur sensible au bruit.

A titre d'exemples nullement limitatifs, de tels transistors forts et faibles signaux équipent des récepteurs de radiomessagerie.

L'invention propose, d'une façon générale, de réaliser au sein d'un même circuit intégré, un émetteur de bruit et un récepteur sensible au bruit tout en assurant un découplage entre l'émetteur et le récepteur, et plus particulièrement à haute fréquence (typiquement au moins de l'ordre de quelques centaines de MHz).

L'invention propose donc un dispositif semi-conducteur comprenant dans un enrobage de résine un circuit intégré possédant des plots de connexion reliés à des pattes métalliques par des fils de liaison.

Selon une caractéristique générale de l'invention, le circuit intégré comporte un substrat semi-conducteur du type substrat sur isolant, comportant une partie inférieure surmontée d'une couche supérieure isolante au sein de laquelle sont réalisés un premier bloc semi-conducteur (dit "émetteur de bruit") et un deuxième bloc semi-conducteur sensible au bruit. Le premier bloc semi-conducteur définit avec la partie inférieure du substrat une première capacité, tandis que le deuxième bloc semi-conducteur définit avec la partie inférieure du substrat une deuxième capacité. Le circuit intégré comporte alors des moyens de découplage disposés au sein de la couche supérieure isolante entre les deux blocs. Ces moyens de découplage comporte au moins un caisson semi-conducteur définissant avec la partie inférieure du substrat une capacité dite "de découplage". La valeur capacitive de la capacité de découplage est supérieure à la valeur capacitive de chacune des première et deuxième capacités.

Ainsi, à haute fréquence, les première et deuxième capacités ont une impédance qui devient faible devant la résistivité du substrat. L'invention réduit alors le couplage large bande en réalisant un chemin d'impédance encore plus faible entre l'émetteur et le récepteur. Ce chemin d'impédance encore plus faible est réalisé par le caisson de découplage dont la valeur capacitive de la capacité de découplage est choisie supérieure à la valeur capacitive de chacune des première et deuxième capacités.

En d'autres termes, on piège les charges électriques injectées dans le substrat par le bloc émetteur, dans un caisson semi-conducteur ménagé entre les deux blocs et présentant une capacité caisson-substrat supérieure à la capacité bloc-substrat de chacun des blocs émetteur et récepteur.

Ceci étant, il est particulièrement avantageux, non seulement de piéger les charges dans le caisson semi-conducteur de découplage, mais également de les évacuer vers la masse. Aussi, généralement, lorsque le premier bloc est relié à une masse externe par une première liaison inductive, tandis que le deuxième bloc est relié à une masse externe par une deuxième liaison inductive, l'invention prévoit avantageusement que le caisson de découplage soit relié à une masse externe par une liaison inductive de découplage, dont la valeur inductive est inférieure ou égale à la valeur inductive de chacune des première et deuxième liaisons inductives.

L'invention permet donc de réaliser ici un chemin de masse d'impédance faible entre l'émetteur et le récepteur. Plus le caisson sera grand, c'est-à-dire plus la valeur capacitive de la capacité de découplage sera grande, meilleur sera l'isolement. Ceci étant, il convient cependant que la fréquence des signaux traités par le deuxième bloc soit inférieure ou égale à la fréquence de résonance des moyens de découplage capacitif inductif ainsi réalisés. En effet, si la fréquence des signaux traités par le deuxième bloc dépasse la fréquence de résonance, l'efficacité du système chute en raison de l'augmentation de l'impédance de la liaison inductive de découplage qui devient importante devant l'impédance du substrat. En d'autres termes, dans ce cas, on supprime ce chemin privilégié vers la masse et on se retrouve dans la situation d'un émetteur qui bruite le récepteur à travers le réseau résistif capacitif du substrat.

L'invention permet donc ici, avec cette contrainte de valeur sur les fréquences, de réaliser un découplage large bande pour des signaux dont la fréquence est inférieure ou égale à la fréquence de résonance des moyens de découplage. Ceci étant, si l'on souhaite réaliser un découplage bande étroite, plus particulièrement centré sur une fréquence particulière de travail, on peut alors ajuster les dimensions du caisson de découplage de façon à ce que la fréquence de résonance des moyens de découplage ainsi formés corresponde à ladite fréquence de travail choisie.

L'invention propose donc une solution radicalement différente de celle, qui vient naturellement à l'esprit de l'homme du métier, et qui consiste à éloigner le plus possible l'émetteur du récepteur avec l'inconvénient d'aboutir alors à des circuits intégrés de très grandes dimensions. L'invention, au contraire, permet, en interposant un circuit de découplage entre l'émetteur et le récepteur, de conserver l'espacement entre l'émetteur et le récepteur, prévu à l'origine lors de la conception. L'invention évite également le remplacement de la partie inférieure du substrat, qui est généralement un substrat silicium dopé P⁻, par un substrat encore plus isolant, par exemple à base de verre, mais qui se traduit par des problèmes technologiques plus importants.

D'autres avantages et caractéristiques de l'invention apparaîtront à l'examen de la description détaillée d'un mode de réalisation, nullement limitatif, et des dessins annexés, sur lesquels :
- la figure 1 illustre très schématiquement une coupe partielle d'un circuit intégré selon l'invention, équipé de moyens de découplage;
- la figure 2 illustre très schématiquement la liaison de ces moyens de découplage à la masse; et
- la figure 3 illustre des courbes de réjection de bruit en fonction de la fréquence.

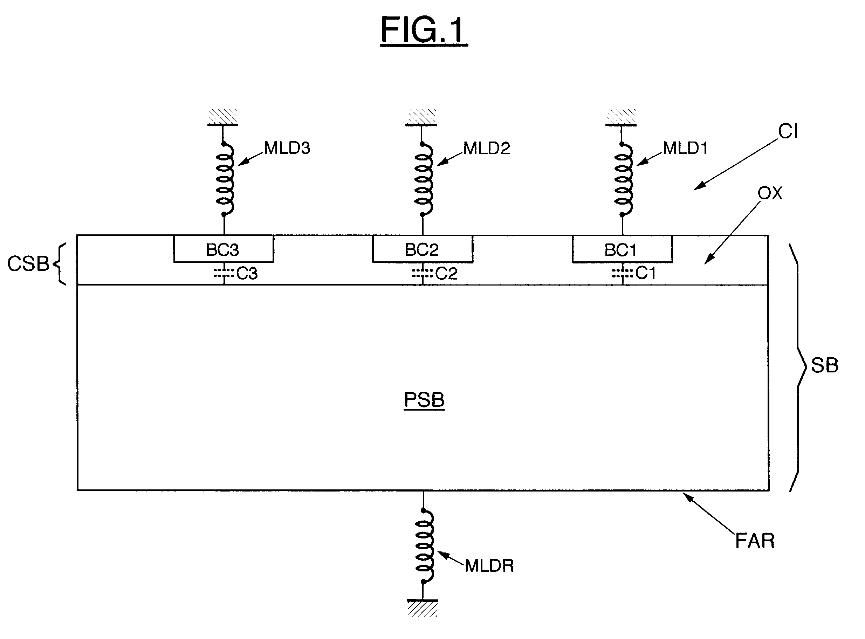

Sur la figure 1, la référence SB désigne d'une façon générale un substrat du type substrat sur isolant (substrat SOI : en langue anglaise "Substrat On Insulator"). Ce type de substrat est bien connu de l'homme du métier. Brièvement, il se caractérise par des îlots de silicium (par exemple les blocs BC 1, BC2 et BC3 sur la figure 1) perdus dans une mer d'oxyde. Le procédé de fabrication d'un tel circuit intégré sur substrat SOI est également bien connu de l'homme du métier. En bref, il consiste à partir d'un substrat de silicium PSB, par exemple d'une épaisseur de 350 microns, et dopé P⁻ (par exemple 10¹⁴ à 10¹⁵ at./cm⁻³), à réaliser sur la face avant de ce substrat PSB, une couche supérieure composée de caissons semi-conducteurs (qui formeront ultérieurement en l'espèce les caissons BC1, BC2 et BC3) reposant sur la face supérieure du substrat PSB, et entourés de région d'oxyde (par exemple du dioxyde de silicium), reposant également sur la face avant du substrat PSB. On procède ensuite à un découpage de l'ensemble ainsi obtenu au niveau de la face avant du substrat PSB. On fait alors croître sur la face avant du substrat PSB une couche d'oxyde, puis on accole, sur la face supérieure de cette couche d'oxyde, la couche supérieure précédemment mentionnée comportant les caissons semi-conducteurs entourés des zones d'oxyde. On obtient alors en final le substrat SB représenté sur la figure 1, sur laquelle la couche supérieure CSB comporte la région oxydante OX au sein de laquelle sont noyés les caissons semi-conducteurs formant les blocs BC1, BC2 et BC3.

La présence d'oxyde OX entre chaque caisson BCi et la partie inférieure PSB du substrat, forme le diélectrique d'une capacité caisson-substrat Ci. La valeur capacitive de cette capacité Ci est proportionnelle à la surface de la face inférieure du caisson en regard de la partie inférieure PSB du substrat. Plus précisément, cette capacité Ci est égale au produit de la constante diélectrique de l'oxyde par la surface du caisson en regard de la partie inférieure PSB du substrat, le tout divisé par l'épaisseur d'oxyde entre le caisson et la partie inférieure du substrat.

On suppose également que le bloc BC3 est de nature à émettre du bruit dans la partie inférieure PSB du substrat. Ce bloc BC3 comporte par exemple un ou plusieurs transistors fort signaux, par exemple des transistors traitant des signaux ayant une puissance de l'ordre du watt. On suppose par ailleurs que le bloc BC1 est un bloc comportant des éléments sensibles au bruit, par exemple des transistors faible signaux devant traiter des signaux ayant une puissance de l'ordre du nanowatt, voire de quelques dizaines de nanowatt.

A très basse fréquence, le couplage d'origine électrique entre l'émetteur BC3 et le récepteur BC1 est très faible en raison de la présence des capacités Cl et C3 qui se comportent alors comme une barrière antibruit.

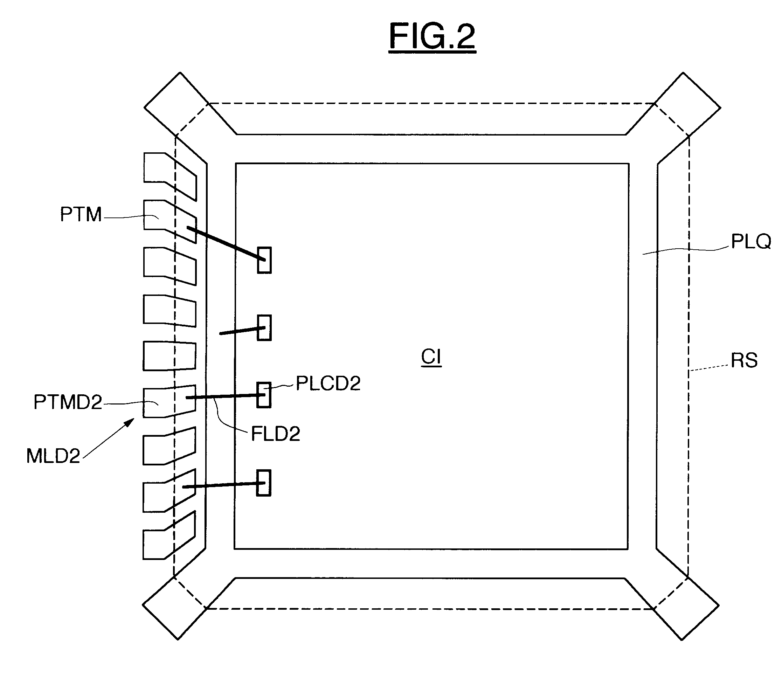

Par ailleurs, la face arrière FAR du substrat est généralement reliée à la masse par des moyens de liaison inductifs MLDR. A cet égard, comme on le voit de façon très schématique sur la figure 2, un circuit intégré repose de façon classique sur une plaque centrale PLQ d'une grille de connexion comportant par ailleurs des pattes de connexion métalliques PTM. L'ensemble est maintenu dans un enrobage de résine RS. Sur la surface du circuit intégré, sont ménagés des plots de connexion reliés par des vias (trous d'interconnexion métalliques) aux différents composants actifs du circuit intégré. Ces différents plots de connexion peuvent être soit connectés sur la plaque centrale PLQ, soit directement aux pattes métalliques PTM, par des fils de liaison soudés. Les fils de liaison et les pattes de connexion métalliques associées forment ces moyens de liaison inductifs dont la valeur de l'inductance peut être connue à un pourcentage près. A titre indicatif, la valeur inductive d'une liaison MLDR (fil + patte métallique) est de l'ordre de 5 nanoHenry. Cette valeur est également généralement celle des moyens de liaison inductifs MLD3 et MLD1 reliant respectivement les blocs BC3 et BC1 à la masse.

La prise face arrière contribue à réduire le couplage à basse fréquence.

Ceci étant, lorsque la fréquence augmente, pour atteindre des hautes fréquences, typiquement plusieurs centaines de MHz et plus, l'impédance de la liaison inductive MLDR croît et supprime alors ce chemin privilégié vers la masse pour l'évacuation des charges électriques de bruit. On se retrouve alors avec un émetteur qui bruite le récepteur à travers le réseau résistif capacitif de la partie inférieure PSB du substrat. L'invention résout alors ce problème du découplage haute fréquence en interposant entre les deux blocs BC1 et BC3 un caisson semi-conducteur de découplage BC2, présentant une capacité caisson-substrat C2, et relié à une masse par des moyens de liaison MLD2 (patte PTMD2 + fil FLD2 reliant le plot PLCD2 à la patte PTMD2).

L'invention part en effet de l'observation qu'à haute fréquence les capacités caisson-substrat ont une impédance qui devient faible devant la résistivité du substrat. En choisissant la valeur capacitive de la capacité C2, supérieure à la valeur capacitive de la capacité C3 et à la valeur capacitive de la capacité C1, on crée un chemin d'impédance faible entre l'émetteur BC3 et le récepteur BC1. Les charges injectées dans la partie inférieure du substrat PSB par l'émetteur vont donc naturellement se diriger dans le caisson de découplage BC2.

Il est par ailleurs particulièrement avantageux de pouvoir en outre éliminer ces charges vers la masse en utilisant les moyens de liaison MLD2 dont la valeur inductive L2 sera avantageusement choisie inférieure ou égale aux valeurs inductives L1 et L3 des blocs BC1 et BC3. On réduit ainsi l'impédance vers la masse à haute fréquence. Il convient de noter ici que la masse peut être une "masse dynamique", c'est-à-dire à un plan d'alimentation assez large par rapport à un plan de masse et entre lesquels il se produit un court-circuit à haute fréquence.

Plus le caisson est grand, meilleur sera l'isolement. Ceci étant, on réalise un découplage du substrat large bande pour des fréquences de signaux inférieures ou égales à la fréquence de résonance du circuit résonant inductif capacitif formée de la capacité C2 et de la liaison inductive MLD2.

En effet, si la fréquence des signaux à traiter dépasse la fréquence de résonance, l'impédance de la liaison inductive MLD2 va augmenter et devenir importante devant la résistance du substrat. On se retrouve alors à nouveau avec un émetteur qui bruite le récepteur à travers le réseau résistif capacitif du substrat.

En d'autres termes, la structure selon l'invention permet un découplage large bande du substrat pour des fréquences inférieures ou égales à 1/4 π² L2C2.

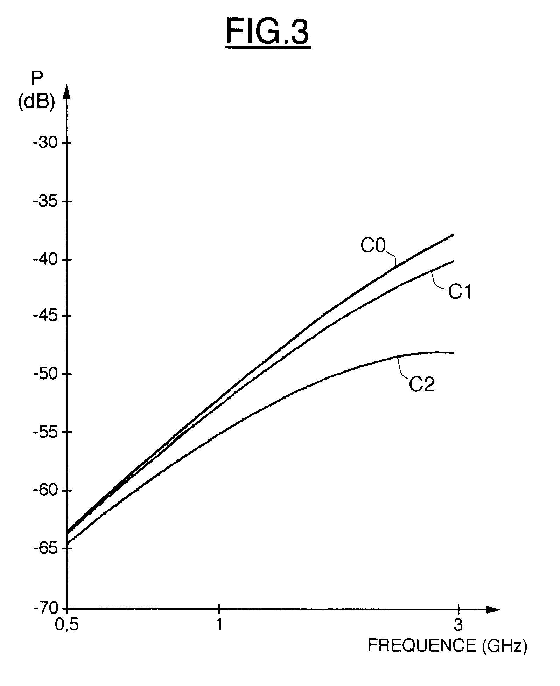

La figure 3 illustre une comparaison entre
- un circuit intégré sans caisson de découplage, dans lequel l'émetteur et le récepteur sont mutuellement éloignés de 100 microns (courbe C0),
- un circuit intégré avec un caisson de découplage de 10 microns de largeur, et un éloignement émetteur-récepteur de 100 microns (courbe C1),
- un circuit intégré avec un caisson de découplage de 90 microns de largeur, et un éloignement émetteur-récepteur toujours égal à 100 microns (courbe C2).

On remarque donc l'efficacité des moyens de découplage à haute fréquence, typiquement à partir d'une fréquence de l'ordre du gigahertz. A basse fréquence, typiquement à 500 MHz, l'impédance du substrat étant plus faible, le bruit de couplage est essentiellement évacué par la face arrière du substrat.

## Revendications

1. Dispositif semi-conducteur comprenant dans un enrobage de résine un circuit intégré possédant des plots de connexion reliés à des pattes métalliques par des fils de liaison, caractérisé par le fait que le circuit intégré (CI) comporte un substrat semi-conducteur (SB) du type substrat sur isolant comportant une partie inférieure (PSB) surmontée d'une couche supérieure isolante (OX) au sein de laquelle sont réalisés un premier bloc semi-conducteur (BC3) définissant avec la partie inférieure du substrat une première capacité (C3), et un deuxième bloc semi-conducteur (BC1) définissant avec la partie inférieure du substrat une deuxième capacité (C2), par le fait que le circuit intégré comporte des moyens de découplage disposés au sein de la couche supérieure isolante entre les deux blocs et comportant au moins un caisson semi-conducteur (BC2) définissant avec la partie inférieure du substrat une capacité de découplage (C2), et par le fait que la valeur capacitive de la capacité de découplage (C2) est supérieure à la valeur capacitive de chacune des première et deuxième capacités (C3, C1).

2. Dispositif selon la revendication 1, caractérisé par le fait que le premier bloc (BC3) est relié à une masse externe par une première liaison inductive (MLD3) et le deuxième bloc (BC1) est relié à une masse externe par une deuxième liaison inductive (MLD1), par le fait que le caisson de découplage (BC2) est relié à une masse externe par une liaison inductive de découplage (MLD2) dont la valeur inductive est inférieure à la valeur inductive de chacune des première et deuxième liaisons inductives, et par le fait que la fréquence de résonance des moyens de découplage est supérieure à la fréquence des signaux traités par le deuxième bloc (BC1).
